# FASCICULE DE BREVET EUROPEEN

(11) **EP 0 612 143 B1**
(45) Date de publication et mention de la délivrance du brevet: **06.05.1999**
(21) Numéro de dépôt: 94200325.2
(22) Date de dépôt: 10.02.1994
(51) Int. Cl.: H03G 1/00, H03G 3/20

(54) **Dispositif amplificateur haute fréquence, station émettrice-réceptrice comportant une tel dispositif et système de radio mobile comportant de telles stations**
HF-Verstärker, Funksendeempfänger mit diesem Verstärker und Mobilfunknetz mit solchem Funksendeempfänger
HF amplifier, transmit-receive station using the amplifier and mobile radio system using the station

(30) Priorité: 17.02.1993 FR 9301804
(43) Date de publication de la demande: 24.08.1994
(73) Titulaire: Koninklijke Philips Electronics N.V., 5621 BA Eindhoven (NL)
(72) Inventeur: Boulic, Claude, F-75008 Paris (FR)
(74) Mandataire: Chaffraix, Jean

(56) Documents cités:
- US-A- 4 216 445
- US-A- 4 656 434
- IEEE TRANSACTIONS ON MICROWAVE THEORY AND TECHNIQUES vol. MTT-27, no. 1 , Janvier 1979 , NEW YORK (USA) pages 89 - 90 L. NYSTRÖM 'a new microwave variable power divider.'
- PATENT ABSTRACTS OF JAPAN vol. 15, no. 62 (E-1033)4 Décembre 1991 & JP-A-02 288 408 (FUJITSU LTD.) 28 Novembre 1990

## Description

La présente invention concerne un dispositif présentant une puissance de sortie variable et comportant un circuit de couplage d'entrée, un circuit de couplage de sortie et une commande de gain constituée par un circuit de désadaptation d'impédance.

De tels dispositifs amplificateurs selon l'invention sont en particulier utilisés pour des stations centrales d'un réseau de radio mobile. Un tel réseau est en effet constitué de plusieurs stations centrales couvrant chacune une zone géographique définie et émettant sur plusieurs canaux de fréquences très proches. Afin d'éviter des interférences entre zones, la puissance de sortie de chaque station centrale doit être strictement limitée à la zone à couvrir.

Le document IEEE TRANSACTIONS ON MICROWAVE THEORY AND TECHNIQUE, Vol. MTT 27, n°1, janvier 1979, pages 89-90 décrit un dispositif d'atténuation variable de puissance qui comporte deux coupleurs, deux diodes varactor, et deux lignes 50 Ω de longueur électrique λ/4.

L'invention a notamment pour but de faire varier la puissance de sortie d'un dispositif amplificateur tout en atténuant l'intermodulation due aux signaux parasites reçus par la sortie du dispositif amplificateur et qui sont issus de dispositifs voisins.

Pour cela, un dispositif présentant une puissance de sortie variable selon l'invention et tel que décrit dans le paragraphe introductif est caractérisé en ce que lesdits circuits de couplage d'entrée et de sortie sont reliés par une première chaîne d'amplification d'une part, et par une seconde chaîne d'amplification d'autre part, ledit circuit de désadaptation d'impédance étant connecté en entrée desdites chaînes d'amplification de telle sorte que les valeurs des impédances d'entrée desdites chaînes d'amplification, ramenées sur les accès du circuit de couplage d'entrée, soient semblables.

Cette structure a l'avantage de permettre d'atténuer l'intermodulation due aux signaux parasites reçus par la sortie du dispositif amplificateur et issus de dispositifs amplificateurs voisins, lorsque la station est composée de plusieurs dispositifs amplificateurs.

Dans un mode de réalisation préférentiel d'un dispositif selon l'invention, le circuit de désadaptation est un circuit à impédance variable constitué d'un groupement de diodes PIN.

Enfin dans un mode de réalisation particulièrement avantageux du dispositif selon l'invention, un circuit de couplage est un coupleur 90°-3dB.

L'invention concerne également une station émettrice-réceptrice pour réseau de radio-mobile qui comporte un tel dispositif amplificateur, ainsi qu'un système de radio-mobile comportant de telles stations.

D'autres particularités, détails et avantages de l'invention seront mis en évidence par la description qui va suivre en regard des dessins annexés qui sont relatifs à des exemples donnés à titre non limitatif dans lesquels :
- les figures 1 et 2 sont des schémas de principe d'un dispositif selon l'invention,
- la figure 3 est un exemple de mise en oeuvre d'un dispositif selon l'invention,
- la figure 4 représente un système de radio-mobile constitué d'une pluralité de station émettrice-réceptrices qui comporte un dispositif amplificateur selon l'invention.

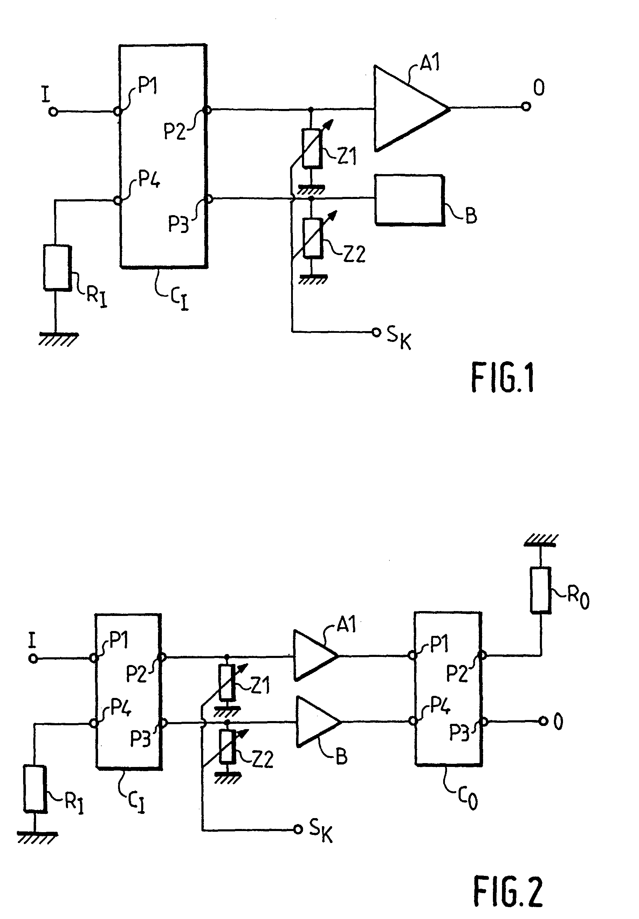

D'après la figure 1, un dispositif amplificateur selon l'invention comporte un circuit de couplage d'entrée Ci,tel que décrit dans le brevet français précité par exemple, disposant de quatre accès numérotés p1 à p4. L'accès p1 constitue l'entrée I du dispositif amplificateur et reçoit le signal haute fréquence. L'accès p2 est relié d'une part à l'entrée d'une première chaîne A1 qui est une chaîne d'amplification, et d'autre part à la première borne d'une première impédance variable Z1 dont la seconde borne est reliée à la terre. L'accès p3 est relié à une seconde chaîne B d'une part et d'autre part à la première borne d'une seconde impédance variable Z2 dont la seconde borne est reliée à la terre. L'accès p4 est un accès d'isolation relié à la terre par l'intermédiaire d'une première résistance Ri. La sortie de la première chaîne A1 constitue la sortie 0 du dispositif amplificateur. Les deux impédances variables Z1 et Z2 sont commandées simultanément par un signal de commande disponible sur l'entrée Sk.

Cette structure, constituée à l'entrée d'un coupleur 90°-3dB, permet de désadapter les impédances d'entrée des deux chaînes A1 et B sans affecter l'étage qui précède le dispositif amplificateur. En effet, les deux impédances Z1 et Z2 varient de telle sorte que les valeurs des impédances d'entrée désadaptées des deux chaînes A1 et B, respectivement ramenées sur les accès p2 et p3 du coupleur d'entrée Ci, soient semblables. Une même proportion de puissance est donc réfléchie vers les accès p2 et p3 du coupleur d'entrée Ci. Or, d'après les propriétés d'un tel coupleur, un signal arrivant sur l'accès p1 issu de l'accès p3 est déphasé de 90° par rapport à un signal issu de l'accès p2; et un signal disponible sur l'accès p3 issu de l'accès p1 est déphasé de 90° par rapport à un signal de même origine disponible sur l'accès p2. Les deux signaux réfléchis sont donc déphasés de 180° sur l'accès p1. L'effet du signal de retour sur l'entrée du dispositif est nul. Par contre, les signaux réfléchis arrivent en phase sur l'accès p4. Ils vont donc s'ajouter et être absorbés par la charge Ri.

D'autre part, lorsqu'un tel dispositif amplificateur est utilisé pour la radio mobile, il est particulièrement avantageux de choisir des chaînes d'amplification travaillant en classe linéaire. En effet, chaque station centrale émettant sur plusieurs canaux de fréquence très proche, cela permet d'éviter les interférences entre canaux.

La figure 2 décrit un autre exemple de réalisation d'un dispositif amplificateur selon l'invention. Les références des éléments communs avec la figure 1 ne sont pas modifiées. Dans cet exemple, un dispositif selon l'invention comporte un coupleur de sortie Co, tel que décrit dans le brevet français précité par exemple, disposant également de quatre accès de connexion numérotés p1 à p4, et les deux chaînes A1 et B sont des chaînes d'amplification. L'accès p1 du coupleur de sortie Co est relié à la sortie de la première chaîne A1. Son accès p2 est un accès d'isolation relié à la terre par l'intermédiaire d'une seconde résistance Ro. Son accès p3 constitue la sortie 0 du dispositif amplificateur. Et son accès p4 est relié à la sortie de la seconde chaîne B.

Lorsque les deux chaînes d'amplification A1 et B sont identiques, la structure décrite ci-dessus présente l'avantage d'atténuer l'intermodulation due aux signaux parasites reçus par la sortie du dispositif amplificateur et issus de dispositifs voisins. En effet, de tels signaux parasites vont intermoduler les étages de sortie des deux chaînes d'amplification avec un déphasage de 90°. Les produits d'intermodulation, qui sont décalés de 90° d'une voie par rapport à l'autre, sont déphasés de 180° sur la sortie du dispositif, et s'annulent donc l'un l'autre.

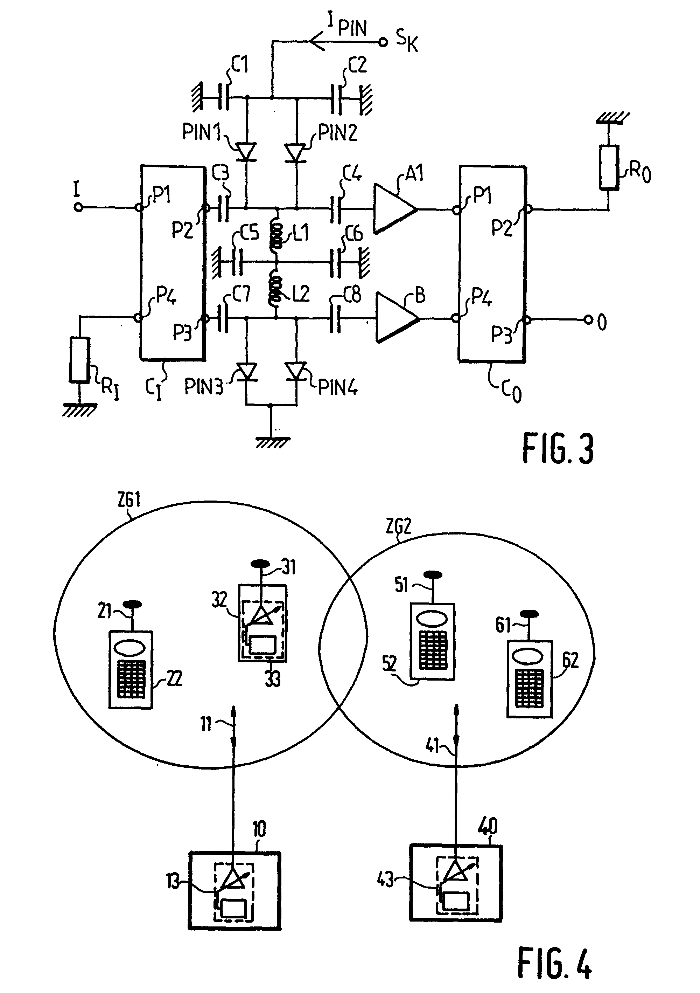

La figure 3 décrit de façon plus détaillée le circuit de désadaptation. Les références des éléments communs avec la figure 2 ne sont pas modifiées. Le circuit à impédance variable comporte quatre diodes PIN appelées PIN1, PIN2, PIN3 et PIN4, deux bobines L1 et L2 et huit condensateurs numérotés C1 à C8. Les deux premières diodes PIN1 et PIN2 sont montées en parallèle. Leurs anodes sont reliées d'une part à l'entrée du signal de commande Sk, et d'autre part à la terre par l'intermédiaire des deux condensateurs C1 et C2 montés en parallèle. Leurs cathodes sont reliées à l'entrée de la première chaîne d'amplification A1 par l'intermédiaire du condensateur C4 et à l'accès p2 du coupleur d'entrée Ci par l'intermédiaire du condensateur C3. Les diodes PIN3 et PIN4 sont montées en parallèle. Leurs cathodes sont reliées à la terre. Leurs anodes sont reliées à l'entrée de la seconde chaîne d'amplification B par l'intermédiaire du condensateur C8 et à l'accès p3 du coupleur d'entrée Ci par l'intermédiaire du condensateur C7. Les cathodes des diodes PIN1 et PIN2 sont reliées aux anodes des diodes PIN3 et PIN4 par l'intermédiaire des deux bobines L1 et L2 montées en série, leur point milieu étant relié à la terre par l'intermédiaire de deux condensateurs C5 et C6 montés en parallèle.

Les condensateurs C3, C4, C7 et C8 permettent d'isoler du circuit de désadaptation, pour le courant continu, le coupleur d'entrée Ci ainsi que les entrées des deux chaînes d'amplification A1 et B. Les condensateurs C1, C2, C5 et C6 constituent des chemins vers la terre pour les hautes fréquences. Grâce aux bobines L1 et L2, les deux groupements de diodes PIN (PIN1, PIN2 et PIN3, PIN4) sont parcourus par le même courant de commande, ce qui a pour effet de leur donner une impédance dynamique pratiquement identique. Ainsi, en faisant varier le courant de commande I_{PIN} disponible sur l'entrée Sk, les impédances d'entrée des deux chaînes d'amplification A1 et B sont désadaptées de façon identique, leur gain est diminué et la puissance de sortie est réduite à la valeur recherchée.

Le dispositif selon l'invention permet d'obtenir des performances particulièrement intéressantes pour une puissance d'entrée de l'ordre de 1W et pour un gain de 20 dB environ.

La figure 4 représente un système de radio-mobile constitué à partir:
- d'une station émettrice-réceptrice centrale 10 disposant d'une antenne d'émission-réception 11 de façon à couvrir une zone géographique ZG1 dans laquelle se déplacent deux mobiles qui disposent respectivement d'une antenne d'émission-réception 21 et 31 et d'une station émettrice-réceptrice mobile 22 et 32,
- et d'une station émettrice-réceptrice centrale 40 disposant d'une antenne d'émission-réception 41 de façon à couvrir une zone géographique ZG2 dans laquelle se déplacent deux mobiles qui disposent respectivement d'une antenne d'émission-réception 51 et 61 et d'une station émettrice-réceptrice mobile 52 et 62.
Les six stations émettrice-réceptrices 10, 22 et 32 d'une part et 40, 52 et 62 d'autre part, comportent respectivement un dispositif amplificateur selon l'invention. Seuls les dispositifs 13, 33 et 43 des stations 10, 32 et 40 sont représentés sur la figure.

En limitant ainsi la puissance de sortie de ces stations, il est possible d'éviter les interférences entre les zones géographiques couvertes par chacune des stations centrales 10 et 40, et entre les différentes stations émettrices-réceptrices.

Il va de soi que des modifications peuvent être apportées aux modes de réalisation qui viennent d'être décrits, notamment par substitution de moyens techniques équivalents, sans que l'on sorte pour cela du cadre de la présente invention.

## Revendications

1. Dispositif présentant une puissance de sortie variable et comportant un circuit de couplage d'entrée (Ci), un circuit de couplage de sortie (Co) et une commande de gain constituée par un circuit de désadaptation d'impédance, caractérisé en ce que lesdits circuits de couplage d'entrée et de sortie sont reliés par un première chaîne d'amplification (A1) d'une part, et par une seconde chaîne d'amplification (B) d'autre part, ledit circuit de désadaptation d'impédance (21,22) étant connecté en entrée desdites chaînes d'amplification (A1,B) de telle sorte que les valeurs des impédances d'entrée desdites chaînes d'amplification, ramenées sur les accès du circuit de couplage d'entrée, soient semblables.

2. Dispositif amplificateur selon la revendication 1, caractérisé en ce que le circuit de désadaptation est un circuit à impédance variable comportant au moins une diode PIN (PIN1, PIN2, PIN3, PIN4).

3. Dispositif amplificateur selon l'une des revendications 1 ou 2, caractérisé en ce qu'un circuit de couplage (Ci, Co) est un coupleur 90°-3dB.

4. Station émettrice-réceptrice (10, 22, 32, 40, 52 et 62) pour réseau de radio-mobile, caractérisée en ce qu'elle comporte un dispositif (13, 33, 43) selon l'une des revendications 1 à 3.

5. Système de radio-mobile, caractérisé en ce qu'il comporte une pluralité de stations émettrice-réceptrices (10, 22, 32, 40, 52, 62) selon la revendication 4.

## Patentansprüche

1. Vorrichtung mit einer variablen Ausgangsleistung und mit einer Eingangs-Kopplungsschaltung (Ci), einer Ausgangs-Kopplungsschaltung (Co) und einer Leistungssteuerung, gebildet aus einer Impedanz-Fehlanpassungsschaltung, dadurch gekennzeichnet, daß die besagten Eingangs- und Ausgangs-Kopplungsschaltungen einerseits über eine erste Verstärkerkette (A1) verbunden sind und andererseits über eine zweite Verstärkerkette (B), die Impedanz-Fehlanpassungsschaltung (21,22) an den Eingang der besagten Verstärkerketten (A1,B) angeschlossen ist, derart, daß die Werte der Eingangsimpedanzen der besagten Verstärkerketten, an den Zugang der Eingangs-Kopplungsschaltung zurückgeführt, ähnlich sind.

2. Verstärkervorrichtung nach Anspruch 1, dadurch gekennzeichnet, daß die Fehlanpassungsschaltung eine Schaltung variabler Impedanz mit mindestens einer PIN-Diode (PIN1, PIN2, PIN3, PIN4) ist.

3. Verstärkervorrichtung nach einem der Ansprüche 1 oder 2, dadurch gekennzeichnet, daß eine Kopplungsschaltung (Ci, Co) ein Koppler 90°-3dB ist.

4. Funksendeempfänger (10, 22, 32, 40, 52 und 62) für Mobilfunknetz, dadurch gekennzeichnet, daß er eine Vorrichtung (13, 33, 43) nach einem der Ansprüche 1 bis 3 enthält.

5. Mobilfunknetz, dadurch gekennzeichnet, daß es eine Vielzahl an Funksendeempfängern (10, 22, 32, 40, 52, 62) nach Anspruch 4 enthält

## Claims

1. An arrangement having a variable output power and comprising an input coupling circuit (C_{I}), an output coupling circuit (C_{O}) and a gain control formed by an impedance mismatch circuit, characterized in that said input and output coupling circuits are connected by a first amplifier system (A1) on the one hand and by a second amplifier system (B) on the other hand, said impedance mismatch circuit (21, 22) being connected to the input of said amplifier systems (A1, B) so that the values of the input impedances of said amplifier systems returned to the accesses of the input coupling circuit are similar.

2. An amplifier arrangement as claimed in Claim 1, characterized in that the mismatch circuit is a variable impedance circuit formed by at least one PIN-diode (PIN1, PIN2, PIN3, PIN4).

3. An amplifier arrangement as claimed in one of the Claims 1 or 2, characterized in that a coupling circuit (C_{I}, C₀) is a 90° -3dB coupler.

4. A transmit-receive station (10, 22, 32, 40, 52 and 62) for a mobile radio network, characterized in that the transmit-receive station comprises an amplifier arrangement (13, 33, 43) as claimed in one of the Claims 1 to 3.

5. A mobile radio system, characterized in that it comprises a plurality of transmit-receive stations (10, 22, 32, 40, 52, 62) as claimed in Claim 4.
